## Europäisches Patentamt

(19) **European Patent Office**

**Office européen des brevets**

(11) Veröffentlichungsnummer: **0 109 127**
**B1**

---

(12) # EUROPÄISCHE PATENTSCHRIFT

(45) Veröffentlichungstag der Patentschrift:
**24.02.88**

(51) Int. Cl.⁴: **H 01 G 9/00**

(21) Anmeldenummer: **83201604.2**

(22) Anmeldetag: **10.11.83**

---

(54) **Elektrolytkondensator.**

---

(30) Priorität: **12.11.82 AT 4136/82**

(43) Veröffentlichungstag der Anmeldung:
**23.05.84 Patentblatt 84/21**

(45) Bekanntmachung des Hinweises auf die Patenterteilung:
**24.02.88 Patentblatt 88/8**

(84) Benannte Vertragsstaaten:
**CH DE FR GB IT LI SE**

(56) Entgegenhaltungen:
**WO-A-82/02978**
**FR-A-2 194 029**
**FR-A-2 303 454**
**US-A-3 124 721**
**US-A-3 516 155**

**IEE, JOURNAL OF ELECTRONIC ENGINEERING,
Nov. 1982, pages 47-50, Y. Shibata "Building a better
aluminium electrolytic capacitor"**

(73) Patentinhaber: **N.V. Philips' Gloeilampenfabrieken,
Groenewoudseweg 1, NL- 5621 BA Eindhoven (NL)**

(72) Erfinder: **Peternell, Hans, p/A INT.
OCTROOIBUREAU B.V. Prof. Holstlaan 6, NL-
5656 AA Eindhoven (NL)**
Erfinder: **Schnapauff, Rudolf, p/A INT.
OCTROOIBUREAU B.V. Prof. Holstlaan 6, NL-
5656 AA Eindhoven (NL)**

(74) Vertreter: **Koppen, Jan, INTERNATIONAAL
OCTROOIBUREAU B.V. Prof. Holstlaan 6, NL-
5656 AA Eindhoven (NL)**

---

EP 0 109 127 B1

**Beschreibung**

Die Erfindung betrifft einen Elektrolytkondensator, der in einem Gehäuse untergebracht ist und zwei koaxiale, von seinen beiden Stirnflächen wegführende Anschlußelemente aufweist, wobei das Gehäuse von einem prismatischen, aus Isoliermaterial bestehenden Hüllkörper umgeben ist, der eine Ausnehmung aufweist, in welcher der Kondensator untergebracht ist und aus welcher zwei Anschlußelemente beidseitig herausragen, wobei diese aus dem Hüllkörper herausragenden Anschlußelemente streifenförmig ausgebildet sind und wobei diese Streifen durch je zweifache Abwinkelung beide auf eine und dieselbe Seitenfläche des Hüllkörpers umgeschlagen sind, wobei ihre Enden auf dieser Seitenfläche in Abstand voneinder liegen.

Ein derartiger Kondensator ist bekannt aus einer Publikation von Y. Shibata, "Building a better aluminium electrolytic capacitor", in Journal of Electronic Engineering, 1 November 1982, Seiten 47 bis 50. Derartige Elektrolytkondensatoren sind in den verschiedensten Ausführungsformen bekannt, sei es als trockener oder nasser Elektrolytkondensator. Beispielsweise zeigt eine solche Ausführungsform die DE-AS 2 438 870.

Die Erfindung hat sich zum Ziel gesetzt, einen solchen Elektrolytkondensator so weiterzubilden, daß er auf einfache Weise auch gut in liegender anordnung in Schaltungsgruppen, wie beispielsweise in Dickfilmschaltungen oder auf Leiterplatten, verwendet werden kann. Erfindungsgemäß wird dies dadurch erreicht, daß das Gehäuse des Kondensators ein zylindrischer Becher ist, daß die Ausnehmung eine durchgehende zylinderartige Ausnehmung ist und daß die Anschlußelementen geplättete einstückige Anschlußdrähte sind. Auf diese Weise ist es nicht notwendig, für den speziellen Verwendungszweck des Elektrolytkondensators in liegender Anordnung eigens dafür einen speziell ausgeführten Elektrolytkondensator herzustellen, sondern es können die in der normalen Produktion anfallenden Elektrolytkondensatoren auf einfache Weise hierfür adaptiert werden, was eine wesentliche Produktionserleichterung mit sich bringt.

Es sei an dieser Stelle erwähnt, daß aus der US-PS 3 124 721 bereits bekannt ist, ein elektrisches Bauelement im Zuge seiner Produktion ausgehend von einer zylindrischen Form flach zu drücken, damit es eine ebene Auflagefläche enhält und die beide, stirnseitig endenden Anschlussfolien auf eine dieser Auflageflächen umzuschlagen. Wie ersichtlich, wird hier von Haus aus ein spezielles Produkt hergestellt und nicht, wie dies bei der vorliegenden Erfindung der Fall ist, ein bereits praktisch fertiges Produkt für den speziellen Verwendungszweck adaptiert. An sich ist es auch schon bekannt, wie die US-PS 3 516 155 zeigt, bei einem zylindrischen elektrischen Bauelement die beiden stirnseitigen Anschlussdrähte in entgegengesetzten Richtungen zweifach abzuwinkeln und mit geplätteten Enden zu versehen, um so ebene Auflageflächen für das Bauelement zu schaffen. Derartige relativ kleine und schwache Auflageflächen gewährleisten jedoch keine sichere und stabile Lage des Bauelementes.

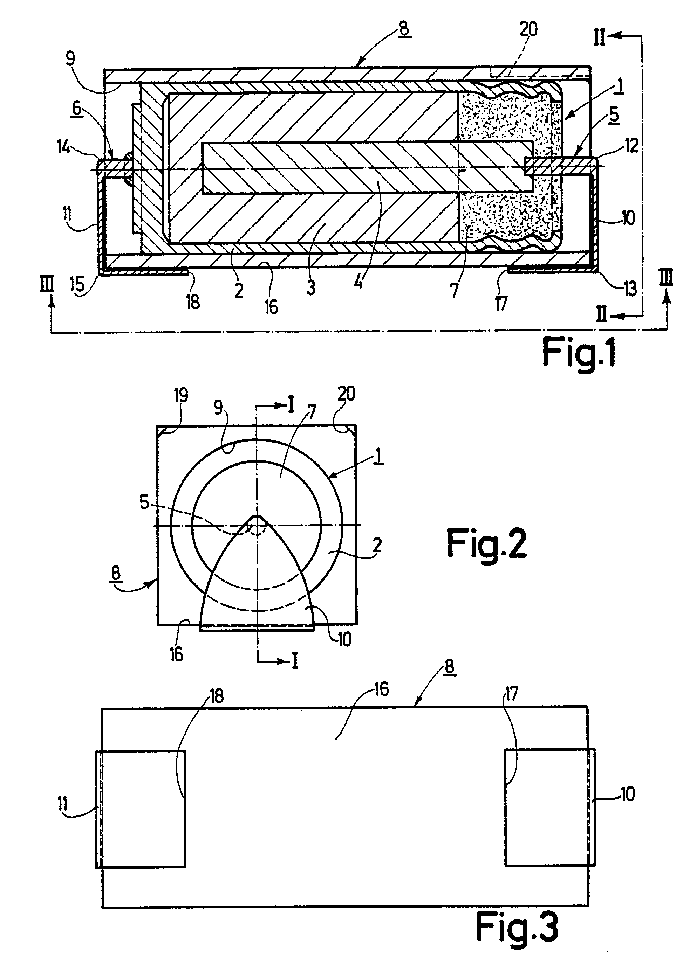

Die Erfindung wird im folgenden anhand der Zeichnung, in der ein Ausführungsbeispiel der Erfindung dargestellt ist, auf das sie jedoch nicht beschränkt sein soll, näher erläutert. Fig. 1 zeigt einen Elektrolytkondensator im Längsschnitt. Fig. 2 zeigt eine Seitenansicht des Elektrolytkondensators gemäss Fig. 1 nach der Linie II-II in Fig. Fig. 3 zeigt eine Seitenansicht des Elektrolytkondensators gemäss Fig. 1 nach der Linie III-III in Fig. 1.

Wie insbesondere Fig. 1 zu entnehmen ist, weist der eigentliche Elektrolytkondensator 1 einen Becher 2 auf, in dem der Wickelkörper 3 untergebracht ist. Dieser Wickelkörper 3 steht mit einer Elektrode umfangsseitig mit der Innenwand des üblicherweise aus elektrisch leitendem Material bestehenden Bechers 2 in elektrisch leitendem Kontakt, wobei diese Kontaktierung natürlich auch auf andere Art und Weise erfolgen könnte. Im Inneren des Wickelkörpers 3 ist zur Kontaktierung mit der anderen Elektrode ein elektrisch leitender Anschlußstreifen bzw. -stift 4 vorgesehen, mit dem seinerseits ein Anschlussdraht 5 verbunden ist, der stirnseitig vom Elektrolytkondensator 1 wegführt. Vom Boden des Bechers 2, der die andere Stirnseite des Elektrolytkondensators bildet, führt ein zweiter Anschlussdraht 6 weg, der elektrisch leitend mit dem Becherboden verbunden ist. Zur Abdichtung des Elektrolytkondensators dient ein aus gummielastischem Material bestehender Stöpsel 7, der in die Becheröffnung eingesetzt und durch Umbördelung des Becherrandes und Verquetschungen des Bechers in demselben festgehalten ist. Der Anschlusstreifen bzw. -stift 4 und der Anschlussdraht 5 sind dabei durch diesen Stöpsel 7 hindurchgeführt. Im Rahmen des bekannten Standes der Technik sind naturlich auch noch andere Arten von Abdichtungen für den Elektrolytkondensator möglich. Ein solcher Elektrolytkondensator 1 stellt ein übliches Produkt dar, das im Handel allgemein erhältlich ist.

Um nun einen solchen Elektrolytkondensator 1 für eine einwandfreie Verwendung als liegendes Bauelement zu adaptieren, ist ein hier vorzugsweise quaderförmiger, aus Isoliermaterial bestehender Hüllkörper 8 vorgesehen, der den Becher 2 umgibt. Hierzu weist der Hüllkörper 8 eine durchgenende zylinderartige Ausnehmung 9 auf, in welcher der Elektrolytkondensator 1 mit dem Becher 2 untergebracht ist und aus welcher die beiden Anschlussdrähte 5 und 6 beidseitig herausragen. Die Querschnittsform der Ausnehmung 9 kann dabei kreisförmig oder polygonal gewählt werden. Ebenso kann die umfangsseitige Querschnittsform des Hüllkörpers 8 polygonal sein, wie beispielsweise fünfeckig. Ein solcher Hüllkörper 8 kann als separater Teil aus Kunststoff hergestellt werden, in dessen Ausnehmung dann der Elektrolytkondensator 1 mit seinem Becher 2 eingesetzt wird. Der Hülkörper 8 kann aber auch dadurch hergestellt werden, dass der Elektrolytkondensator 1 in einer entsprechenden Form unmittelbar mit Kunststoff umspritzt wird.

Weiters werden die aus der Ausnehmung 9 des Hüllkörpers 8 herausragenden Anschlussdrähte 5 und 6 zu Streifen 10 bzw. 11 geplättet und diese Streifen 10 und 11 dann durch je zweifache Abwinkelung 12, 13 bzw. 14, 15 beide auf eine und dieselbe Seitenfläche 16 des Hüllkörpers 8 umgeschlagen, wobei durch entsprechende Ablängung der Streifen 10 und 11 ihre Enden 17 bzw. 18 auf dieser Seitenfläche 16 in Abstand voneinander liegen. Die Abwinkelungen 12, 13 bzw. 14, 15 werden dabei in der Weise vorgenommen, dass die Streifen 10 bzw. 11 unter Vorspannung am Hüllkörper 8 anliegen, wodurch ihre Lage gesichert ist. Eine solche Lagesicherung der Streifen 10 bzw. 11 könnte natürlich auch auf andere Weise erfolgen, beispielsweise dadurch, dass die an der Seitenfläche 16 des Hüllkörpers 8 anliegenden Streifenabschnitte an dieser Seitenfläche angeklebt werden. Selbstverständlich könnte auch das Plätten der Anschlussdrähte zu Streifen vor dem Anbringen des Hüllkörpers 8 um den Elektrolytkondensator 1 erfolgen.

Ein derart adaptierter Elektrolytkondensator ist nun sehr gut zur Verarbeitung in einer Schaltungsgruppe als liegendes Bauelement geeignet, da durch die prismatische Form des Hüllkörpers eine Seitenfläche desselben eine stabile Auflagefläche bildet und die zu Streifen geplätteten Anschlussdrähte nach Umschlagen dieser Streifen auf die betreffende Seitenfläche des Hüllkörpers eine gute Kontaktierung ermöglichen. Die Produktion eines solchen Elektrolytkondensators ist besonders einfach, da hierzu nur die in der Produktion anfallenden üblichen Elektrolytkondensatoren in der vorstehend angeführten Art und Weise weiter auszugestalten sind.

Wie aus Fig. 3 ersichtlich ist, verlaufen beim vorliegenden Ausführungsbeispiel die an der Seitenfläche 16 des Hüllkörpers 8 anliegenden Streifenabschnitte, in Längsrichtung gesehen, zueinander fluchtend. Durch entsprechende Formgebung der Streifen 10 bzw. 11 kann aber auch erreicht werden, dass die an der Seitenfläche 16 des Hüllkörpers 8 anliegenden Streifenabschnitte, in Querrichtung gesehen, mit Abstand zueinander verlaufen und daher, in Längsrichtung gesehen, nicht zueinander fluchten, was im Hinblick auf die elektrischen Anschlussmöglichkeiten wünschenswert sein kann.

Zweckmässigerweise ist der Hüllkörper 8 an einem stirnseiten Ende auch noch mit mindestens einer, vorzugsweise maschinell abtastbaren Markierung versehen, um die Polarität des Elektrolytkondensators zu kennzeichnen. Im vorliegenden Fall sind hierzu, wie insbesondere aus Fig. 2 ersichtlich ist, die der Seitenfläche 16 gegenüberliegenden Kanten des Hüllkörpers 8 abschnittsweise mit Abschrägungen 19 bzw. 20 versehen.

Falls erwünscht, können auch die beiden seitlich offenen Enden der Ausnehmung 9 im Hüllkörper 8 mit einer isolierenden Vergussmasse ausgefüllt werden, was zu einer Verbesserung der Isolationseigenschaften beitragen kann.

Wie aus vorstehendem ersichtlich, gibt es eine Reihe von Abwandlungen des beschriebenen Ausführungsbeispiels, ohne dass dabei der Rahmen der Erfindung verlassen wird.

## Patentansprüche

1. Elektrolytkondensator (1), der in einem Gehäuse (2) untergebracht ist und zwei koaxiale, von seinen beiden Stirnflächen wegführende Anschlußelemente (5, 6) aufweist, mit einem das Gehäuse (2) umgebenden prismatischen, aus Isoliermaterial bestehenden Hüllkörper (8), der eine Ausnehmung (9) aufweist, in welcher der Kondensator (1) untergebracht ist und aus welcher zwei Anschlußelemente (10, 11) beidseitig herausragen, wobei diese aus dem Hüllkörper herausragenden Anschlußelemente (10, 11) streifenförmig ausgebildet sind und diese Streifen (10, 11) durch je zweifache Abwinkelung (12, 13, 14, 15) beide auf eine und dieselbe Seitenfläche (16) des Hüllkörpers (8) umgeschlagen sind und ferner ihre Enden (17, 18) auf dieser Seitenfläche (16) in Abstand voneinander liegen, dadurch gekennzeichnet, daß das Gehäuse (2) des Kondensators (1) ein zylindrischer Becher ist, daß die Ausnehmung (9) eine durchgehende zylinderartige Ausnehmung ist und daß die Anschlußelementen (10, 11) geplättete einstückige Anschlußdrähte (5, 6) sind.

## Claims

1. An electrolytic capacitor (1) which is accommodated in a cup (2) and comprises two coaxial connection elements (5, 6) leading away from its two end faces, comprising a prismatic casing (8) of an insulating material surrounding the cup (2) and having a recess (9) in which the capacitor (1) is accommodated and from which two connection elements (10, 11) project at each end, said connection elements (10, 11) which project from the casing being in the form of strips, said strips (10, 11), by being bent-over two times (12, 13, 14, 15) being both turned down on one and the same side surface (16) of the casing (8), said ends (17, 18) on said side surface (16) being spaced from each other, characterized in that the cup (2) of the capacitor (1) is a cylindrical cup, that the recess (9) is a continuous cylindrical
recess, and that the connection elements (10, 11)
are flattened integral connection wires (5, 6).

**Revendications**

Condensateur électrolytique (1), qui est logé
dans un boîtier (2) et qui présente deux élémemts
de commexion coaxiaux (5, 6) s'étendant à partir
de ses faces termimales, le boîtier (2) étant
entouré d'un corps enveloppant prismatique (8),
constitué par du matériau isolant et présentant
une cavité (9) dans laquelle est logé le
condensateur (1) et dont sortent des deux côtés
deux élémemts de connexiom (10, 11), ces
éléments de connexion (10, 11) sortant du corps
enveloppant étant en forme de bande et ces
bandes (10, 11) étant rabattues chacune par un
double pliage (12, 13, 14, 15) sur une même face
latérale (16) du corps enveloppant (8), leurs
extrémités (17, 18) étant espacées les unes des
autres sur cette face latérale (16), caractérisé en
ce que le boîtier (2) du condensateur (1) est un
boîtier cylindrique, que la cavité (9) est une cavité
cylindrique continue et que les éléments de
connexion (10, 11) sont des fils de connexion
aplatis en une seule pièce (5, 6).

0 109 127

Fig.1

Fig.2

Fig.3

1